# EUROPEAN PATENT SPECIFICATION

(11) **EP 1 631 134 B1**
(45) Date of publication and mention of the grant of the patent: **01.06.2011**
(21) Application number: 05253770.1
(22) Date of filing: 17.06.2005
(51) Int. Cl.: H05K 3/46

(54) **Multilayer circuit board and method of producing the same**
Mehrschichtige Leiterplatte und Verfahren zur Herstellung derselben
Carte de circuit multicouche et son procédé de fabrication

(30) Priority: 27.08.2004 US 927931
(43) Date of publication of application: 01.03.2006
(73) Proprietor: San -Ei Kagaku Kabushiki Kaisha, Tokyo, 114-0004 (JP)
(72) Inventor: Sato, Kiyoshi c/o San-Ei Kaguku Kabushiki Kaisha, Kita-ku Tokyo 114-0004 (JP); Kitamura, Kazunori c/o San-Ei Kaguku Kabushiki Kaisha, Kita-ku Tokyo 114-0004 (JP)
(74) Representative: Copsey, Timothy Graham

(56) References cited:
- US-A- 4 096 626
- US-A- 5 500 278
- US-A1- 2002 170 171
- US-A1- 2003 222 340
- US-A1- 2004 060 173
- US-A1- 2004 134 875

## Description

### BACKGROUND OF THE INVENTION

The present invention relates to a multilayer circuit board and a method of producing the same.

One conventional multilayer circuit board is disclosed in Japanese Patent Application Publication No. 11-274723. In this circuit board, via holes are filled with a metal conductor using an electroplating method in order to improve quality and reliability of a via connection between conductor wiring layers. Such a circuit board is produced using a build-up method. In the build-up method, an insulation layer and a conductor wiring layer are formed, which consists of one cycle which is then repeated.

However, if defects are produced on the insulation layer or the conductor wiring layer in the middle cycles of the build-up method, it is difficult to remove only the defective layer or layers. As a result, both defective layer or layers and non-defective layer or layers are inevitably discarded, resulting in a waste of material.

To overcome this problem, a batch press method is considered to be an alternative. In the batch press method, a double-sided board on which a pattern having vias filled with a conductor material is formed on both surfaces and a via sheet having vias filled with a conductor material are produced in advance. The double-sided board and the via sheet are laminated alternately until the predetermined number of the boards and the sheets are obtained. The outermost layers are sandwiched by copper foils for circuit formation to provide a laminate. The laminate is pressed, i.e., thermally pressed, to be junctured. Thereafter, the circuits are formed on the outermost layers by an etching method to produce the multilayer circuit board.

In the batch press method, the substrates and the sheets are inspected for defects, any defective substrates and sheets are removed in advance, and only the inspected substrates and sheets are used. Accordingly, no defects are produced on the insulation layer or the conductor wiring layer in the middle cycles, thereby reducing fraction defectives and production costs.

Japanese Patent Application Publication No. 2001-7530 discloses the multilayer circuit board produced by the batch press method. Such a multilayer circuit board is produced by laminating prepregs having vias filled with a conductor onto both surfaces of the double-sided circuit board, and then thermally pressing them.

However, when the prepregs having the vias filled with a metal, such as copper, sandwich the double-sided circuit board and are thermally pressed, a connection between metal layers, for example between copper in the vias and the circuit pattern, becomes insufficient, which leads to reduced connection reliability.

US 2002/41,70171 describes a multilayer printed circuit board comprising a plurality of core substrates having conductor patterns, at least one insulating layer provided between the plurality of core substrates, and at least one connection between the plurality of core substrates.

US 5,500,278 describes a multilayer substrate for use as a hybrid integrated circuit. The multilayer substrate is formed from a plurality of layered insulating layers, at least one of which is provided with an inner-layer wiring space.

US 2004/0060173 describes a process for producing interconnects in a multilayer printed circuit, said circuit comprising a stack of printed circuits.

US 2003/0222340 describes a multilayer circuit board in which a plurality of insulating layers and a plurality of conductive layers, each of which includes a conductive pattern, have been laminated.

### BRIEF SUMMARY OF THE INVENTION

Accordingly, it is an object of the present invention to provide a multilayer circuit board having excellent quality and reliability in a via connection between conductor wiring layers (circuit patterns) while generating less delamination resulting in reduced fraction defectives and low costs.

The present inventors carried out intensive research, and discovered that the object is achieved by alternately laminating the predetermined numbers of via sheets and pattern sheets, the via sheets being produced by filling vias with a metal, and plating a surface of the metal; and the pattern sheets produced by plating surfaces of circuit patterns, whereby a laminate is formed, and thermally pressing both sides of the laminate. The present invention is made based on the above-mentioned discovery.

One aspect of the present invention is a multilayer circuit board comprising a conductor wiring layer, and an insulation layer, wherein the conductor wiring layer and the insulation layer are laminated alternately, wherein the conductor wiring layer is electrically connected by a via through the insulation layer, wherein the via is filled with a conductor material, and wherein the conductor material is junctured to the conductor wiring layer with an alloy. According to the present invention there is provided a multilayer circuit board comprising: a circuit pattern-forming sheet, and an insulation layer, wherein the circuit pattern-forming sheet comprises a conductor wiring layer and insulation material adjacent the conductor wiring layer, the circuit pattern-forming sheet and the insulation layer being laminated alternately, the conductor wiring layer being electrically connected by a via through the insulation layer, the via being filled with a conductor material, characterized in that the conductor material is junctured to the conductor wiring layer with an alloy, the components of which comprise plating metals formed on a surface of a planarized conductor material and on a surface of a planarized conductor wiring layer, the alloy being electrically connected to the conductor wiring layer at a first junction surface and electrically connected to the conductor material in the via at a second junction surface.

Another aspect of the present invention is a method of producing the multilayer circuit board described above comprising the steps of laminating required numbers of via-forming sheets and circuit pattern-forming sheets alternately to form a laminate, and thermally pressing both sides of the laminate, wherein each via-forming sheet is formed by forming a via on an base material, filling the via with a conductor material, planarizing a surface of the conductor material, and plating the planarized surface, and wherein each circuit pattern-forming sheet is formed by perforating a hole for a circuit pattern on an base material, filling the hole for the circuit pattern with a conductor material, planarizing a surface of the conductor material to form the circuit pattern, and plating a surface of the circuit pattern with a metal that can produce an alloy.

### BRIEF DESCRIPTION OF THE DRAWINGS

Fig. 1 is a sectional view of a multilayer circuit board according to the present invention;

Fig. 2 shows steps of producing a via-forming sheet;

Fig. 3 shows steps of producing a circuit pattern-forming sheet;

Fig. 4 is a sectional view showing a state that a via-forming sheet is sandwiched and thermally pressed between circuit pattern-forming sheet;

Fig. 5 shows steps of producing a via-forming sheet in Example 1;

Fig. 6 shows steps of producing a circuit pattern-forming sheet in Example 1;

Fig. 7 is a sectional view showing a state that a via-forming sheet is sandwiched and thermally pressed between circuit pattern-forming sheet in Example 1;

Fig. 8 is a sectional view of a multilayer circuit board of Example 1 according to the present invention;

Fig. 9 shows steps of producing a via-forming sheet in Example 2;

Fig. 10 shows steps of producing a circuit pattern-forming sheet in Example 2;

Fig. 11 is a sectional view showing a state that a via-forming sheet is sandwiched and thermally pressed between circuit pattern-forming sheet in Example 2; and

Fig. 12 is a sectional view of a multilayer circuit board of Example 2 according to the present invention.

### DETAILED DESCRIPTION OF THE PREFERRED EMBODIMENTS

The present invention will be described below in detail.

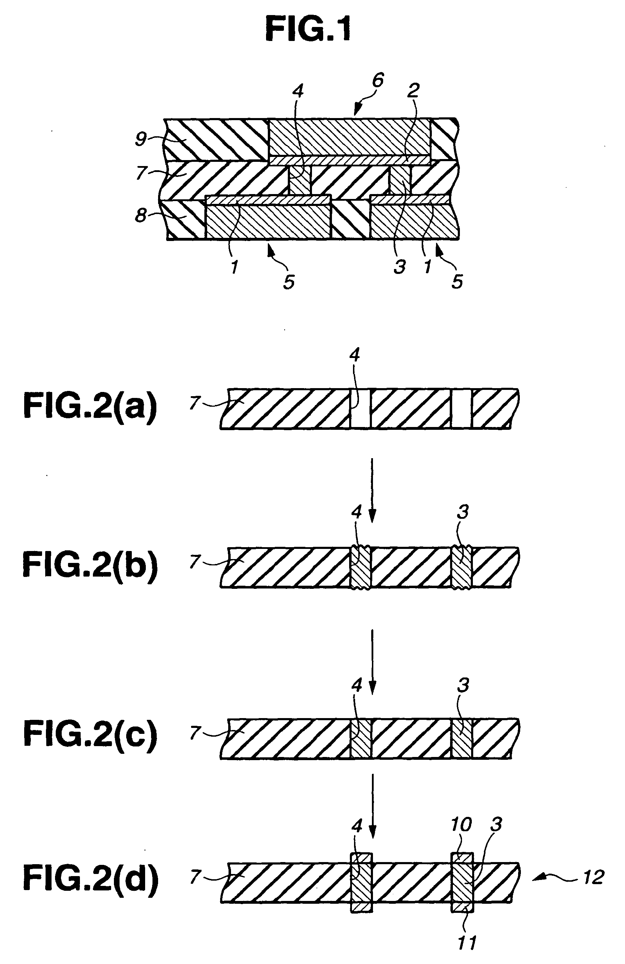

The multilayer circuit board of the present invention comprises a conductor wiring layer (circuit pattern) and an insulation layer that are laminated alternately. The numbers of the lamination are limited, and are selected as required. As an example, Fig. 1 shows a three-layer circuit board comprising conductor wiring layers 5 and 6, and an insulation layer 7 sandwiched therebetween. Vias 4 penetrate through the insulation layer 7, and are filled with a conductor material 3, whereby a via connection between the conductor wiring layers 5 and 6 has improved quality and reliability.

As shown in Fig. 1, in the three-layer circuit board according to one embodiment of the present invention, the conductor material 3 is junctured to the conductor wiring layer 5 with an alloy 1, and is junctured to the conductor wiring layer 6 with an alloy 2. The via connection between the conductor wiring layers 5 and 6 can be assured, and delamination strength is improved.

The multilayer circuit board of the present invention is produced by laminating required numbers of via-forming sheets and circuit pattern-forming sheets alternately to form a laminate, and thermally pressing both sides of the laminate. Specifically, the three-layer circuit board of the present invention is produced as follows:

Firstly, a via-forming sheet 12 is produced by forming vias 4 in an base material (dielectric layer), as shown in Fig. 2a. The base material 7 is either a single layer board or a laminated board. The laminated board may be a single sheet or a composite sheet. Examples include insulation plastic films or sheets comprising a resin such as phenol resin, epoxy resin, polyimide, BT resin, polyester and engineering plastics, i.e., PPO, PPS and the like, a reinforcing material such as a glass cloth and paper impregnated with these resins, and a laminated matter thereof. Among them, epoxy resin, polyimide and engineering plastics are preferable taking into consideration the strength and the heat resistance of the base material 7.

The vias 4 are formed by a laser beam machining using CO2 laser, Nd:YAG laser, YAG laser or excimer laser, an exposing and developing method using a photosensitive insulation material, a plasma machining method, a mechanical machining method using a puncher or a drill, a photolithography machining method, and a dry etching machining method. Among them, the photosensitive insulation material and plasma machining method are preferable when taking productivity into consideration.

Then, the vias 4 are filled with the conductor material 3 as shown in Fig. 2b. The conductor material 3 comprises a metal, a conductive composition or the like. Examples of the metal include pure metals such as gold, silver, cooper, nickel, indium, tin, lead and zinc, and an alloy thereof, i.e., a tin-silver alloy, and solder. Examples of the conductive composition include a mixture of powder of the metal above described and a resin such as epoxy resin and a polyimide resin. Preferably, the conductor material 3 is copper in view of the conductivity and the costs.

The vias 4. are filled with the conductive material 3, i.e., the metal, using a wet plating method including electrolytic plating and electroless plating, and a dry plating method including deposition, sputtering, thermal spraying, and solder covering. The wet plating method is preferable in that the costs are low.

The surface of the conductor material 3 in each via 4 is planarized as shown in Fig. 2c. Planarization can reduce signal noises, and improve junction and air bubble removal. Planarization is conducted by mechanical polishing with a buff including a polishing material, i.e., ceramics, or a polishing paper, a blush, vibration.

The planarized surfaces are plated to form plated layers 10 and 11 as shown in Fig. 2d. A plating metal may be the same metal cited in the conductor material 3. Examples include an alloy plating such as a tin-silver plating and a solder plating, and a pure metal plating such as a tin plating and a copper plating. Preferable is a nickel-gold plating or a tin plating in view of connection reliability. The surface is plated by the wet plating or the dry plating as cited above. The wet plating method is preferable in that the costs are low. Each plated layer 10 or 11 has a thickness of 0.01 to 20 µ.

The plated layers 10 and 11 may comprise the same or different plating. For example, when electroless plating is conducted, the plated layers 10 and 11 comprise the same plating. When plating is conducted twice, the plated layers 10 and 11 comprise the different plating.

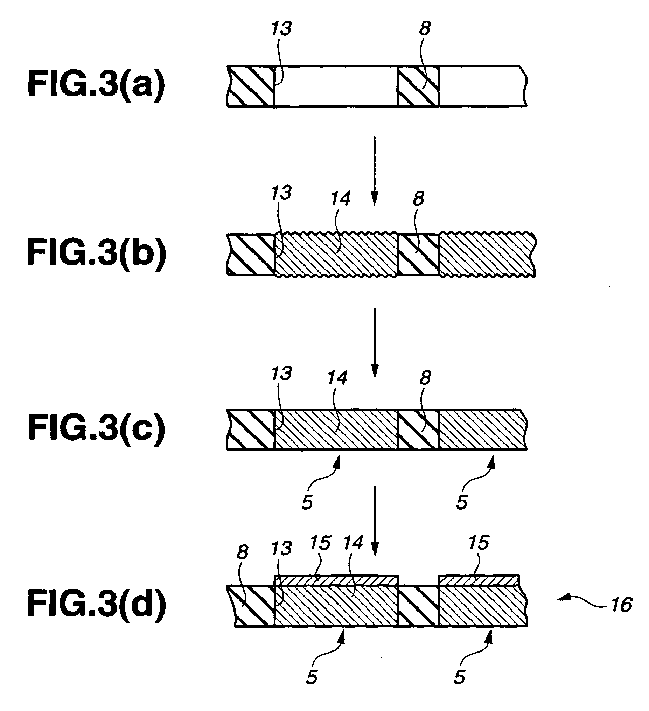

A circuit pattern-forming sheet 16 is formed by perforating an base material (dielectric layer) 8 to form holes 13 for a circuit pattern as shown in Fig. 3a. The base material 8 may be the same material used in the base material 7. Perforation may be conducted similarly to the formation of the vias 4.

Then, the holes 13 are filled with a conductor material 14 as shown in Fig. 3b. The conductor material 14 may be the same material as cited in the conductor material 3. Filling may be conducted similarly to the filling of the vias 4.

The surfaces of the conductor material 14 are planarized to form a circuit pattern (conductor wiring layer) 5 as shown in Fig. 3c. Planarization can reduce signal noises, and improve junction and air bubble removal. Planarization is conducted similarly to the planarization of the surfaces of the conductor material 3.

One of the planarized surfaces is plated to form a plated layer 15 as shown in Fig. 3d. A plating metal and a plating method is cited in the case of plating the plated layers 10 and 11. Preferable is a nickel-gold plating or a tin plating in view of air bubble removal.

The plating metal of the plated layer 15 forms an alloy with the plating metal of the plated layer 11 on the surface of the conductor material 3, when the circuit pattern-forming sheet 16 and the via-forming sheet 12 are laminated. Accordingly, the plating metal of the plated layer 15 and the plating metal of the plated layer 11 should be combined so that an alloy is formed. Example combinations include a gold plating and a tin plating, and a solder plating and a tin plating.

In Fig. 3, only one surface of the circuit pattern-forming sheet 16 is plated, but both surfaces may be plated. Plating can be conducted by electrolytic plating one surface at a time. Alternatively, both surface may be subjected to electroless plating, and a plated layer on one surface may be removed with a dissolving agent such as hydrochloric acid and nitric acid.

Plating both surfaces can be conducted by electroless plating. Alternatively, only one surface may be subjected to electrolytic plating, and then the other surface may be subjected to electrolytic or electroless plating. In this case, one surface and the other surface may be plated with the same plating liquid or with different plating liquids.

As described above, the required numbers of the via-forming sheets and the circuit pattern-forming sheets are produced. Similar to the circuit pattern-forming sheet 16, a circuit pattern-forming sheet 18 including an insulation layer 9, a conductor wiring layer 6 and a plated layer 17 is produced.

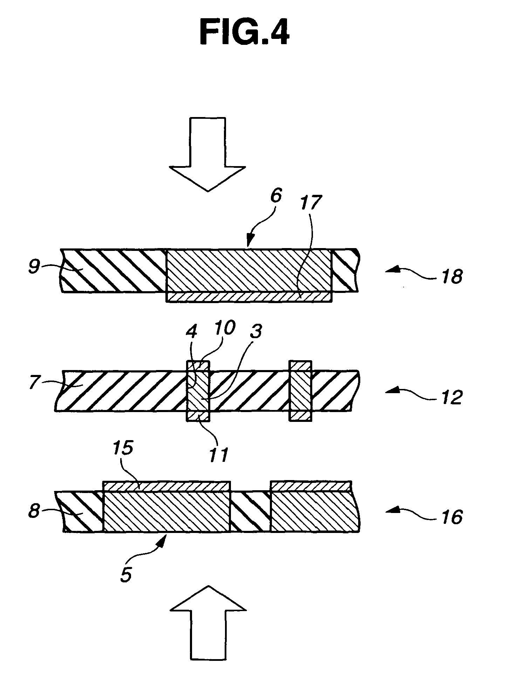

The via-forming sheet 12 and the circuit pattern-forming sheets 16 and 18 are laminated alternately to form a laminate. The laminate is thermally pressed such that top and bottom surfaces are sandwiched as shown in Fig. 4. Thermal press may be, for example, conducted by a vacuum press machine at 150 to 400°C, preferably at 150 to 350°C, most preferably at 150 to 300°C for 30 to 300 minutes.

By the thermal press, the plating layers 11 and 15 are contacted and thermodiffused to form an alloy 1. The conductor material 3 of the vias 4 are junctured to the conductor wiring layer (circuit pattern) 5 with the alloy 1 as shown in Fig. 1. Similarly, the plating layers 10 and 17 are contacted and thermodiffused to form an alloy 2. The conductor material 3 of the vias 4 are junctured to the conductor wiring layer (circuit pattern) 6 with the alloy 2 as shown in Fig. 1. When the plated layers 10, 11, 15 and 17 are solder, alloy junction, i.e., so-called "soldering" can be conducted by low temperature thermal press.

When the insulation layers 7, 8 and 9 contain thermally fused or thermally reactive resin, the resin is also contacted and thermally fused or reacted by the thermal press. Therefore, the insulation layers 7, 8 and 9 are also junctured integrally.

As a result, in the multilayer circuit board of the present invention, the via connection between the conductor wiring layers 5 and 6 is ensured, thereby providing high electrical connection reliability and improved delamination strength.

The present invention will be better understood by referring to the accompanied drawings.

### Example 1

### (Production of via-forming sheet)

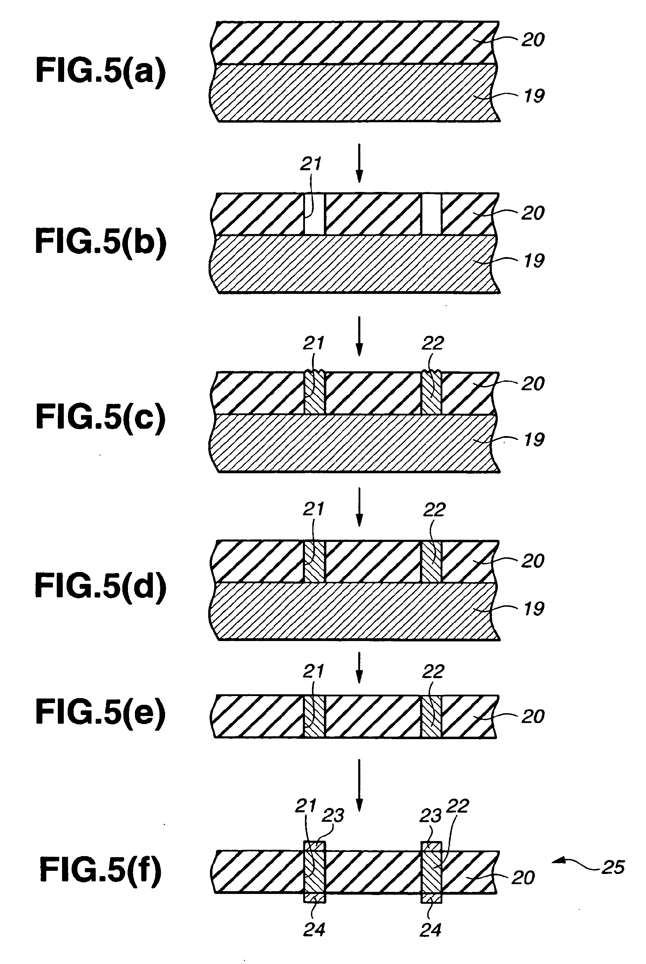

A photosensitive resin composition was coated on a stainless steel support 19 having a thickness of 100 µ, and dried at 80°C for 30 minutes to provide a coating film 20 having a thickness of 50 µ, as shown in Fig. 5a. The coating film 20 was contacted with a negative mask, and irradiated with an extra-high pressure mercury lamp at 1000 mj/cm². Unexposed portions were developed by using an organic solvent at a spray pressure of 2 Kg/cm² for 1 minute.

The support 19 coated with the coating film 20 was heated and cured at 160°C for 1 hour to form vias 21 each having a depth of 50 µ, as shown in Fig. 5b. The vias 21 were electroplated with copper 22 to a thickness of about 50 µ, whereby the vias 21 were completely filled with the copper 22, as shown in Fig. 5c. The surfaces of the copper 22 on the support 19 was polished by a ceramic buff at a load power of 1.5 ampere, as shown in Fig. 5d. After the polishing, the support 19 was peeled away, as shown in Fig. 5e. The surfaces of the vias 21 filled with the copper 22 were subjected to tin electroless plating to form plated layers 23 and 24, each having a thickness of 1 µ, as shown in Fig. 5f . Thus, a via sheet 25, i.e., a via-forming sheet, was produced.

In Example 1, the photosensitive resin composition us as follows (by weight): 100 parts of cresol novolac type epoxy resin, 90 parts of phenol novolac resin, 30 parts of a sulfonium salt type cation photopolymerization initiator, 30 parts of 2-ethyl-9,10-dimethyl oxyethoxy anthracene, 100 parts of barium sulfate, 1 part of an antifoaming agent, and 100 parts of a solvent.

### (Production of circuit pattern-forming sheet)

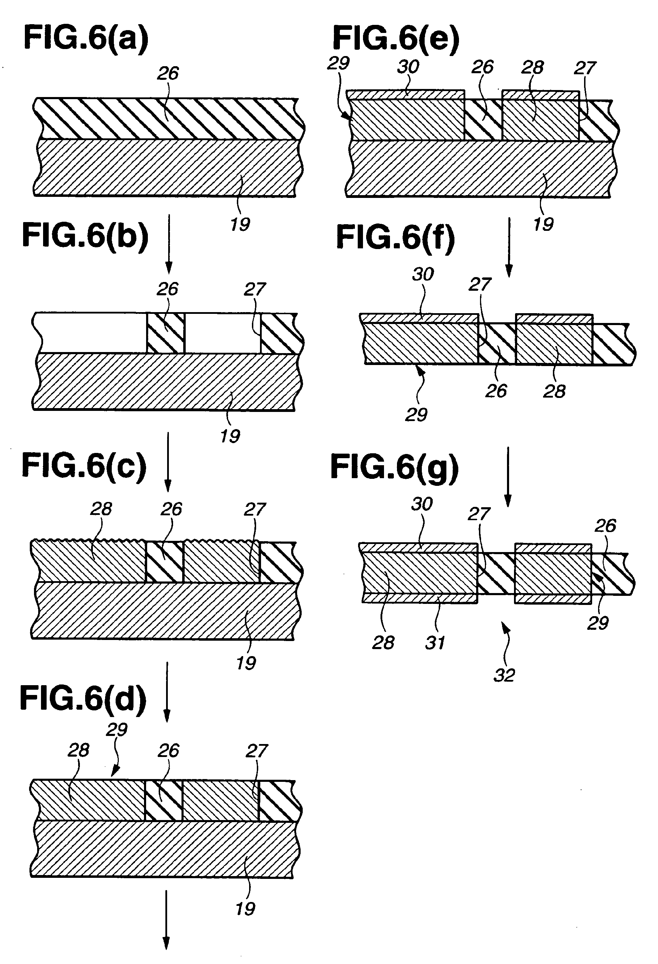

The above-described photosensitive resin composition was coated on a stainless steel support 19 having a thickness of 100 µ, and dried at 80°C for 30 minutes to provide a coating film 26 having a thickness of 50 µ, as shown in Fig. 6a. The coating film 26 was contacted with a negative mask, and irradiated with an extra-high pressure mercury lamp at 1000 mj/cm². Unexposed portions were developed by using an organic solvent at a spray pressure of 2 Kg/cm² for 1 minute.

The support 19 coated with the coating film 26 was heated and cured at 160°C for 1 hour to form holes 27 for a circuit pattern each having a depth of 50 µ, as shown in Fig. 6b. The holes 27 were electroplated with copper 28 to a thickness of about 50 µ, whereby the holes 27 were completely filled with the copper 28, as shown in Fig. 6c. The surfaces of the copper 28 on the support 19 were polished by a ceramic buff at a load power of 1.5 ampere to form a circuit pattern 29, as shown in Fig. 6d. One of the surfaces of the circuit pattern 29 on the support 19 was electrolytic nickel-gold plated (bonding gold-plated) to form a plated layer 30 having a thickness of 10 µ, as shown in Fig. 6e. Thereafter, the support 19 was peeled away, as shown in Fig. 6f. The other surface of the circuit pattern 29 was electroless gold plated to form a plated layer 31 having a thickness of 1 µ, as shown in Fig. 6g. Thus, a pattern sheet 32, i.e., a circuit pattern-forming sheet, was produced.

Similarly, a pattern sheet 37 including a circuit pattern 33 and a coating film 36 was produced. The circuit pattern 33 had a plated layer 34 formed by electroless gold plating on one surface and a plated layer 35 formed by bonding gold-plating on the other surface.

### (Production of multilayer circuit board)

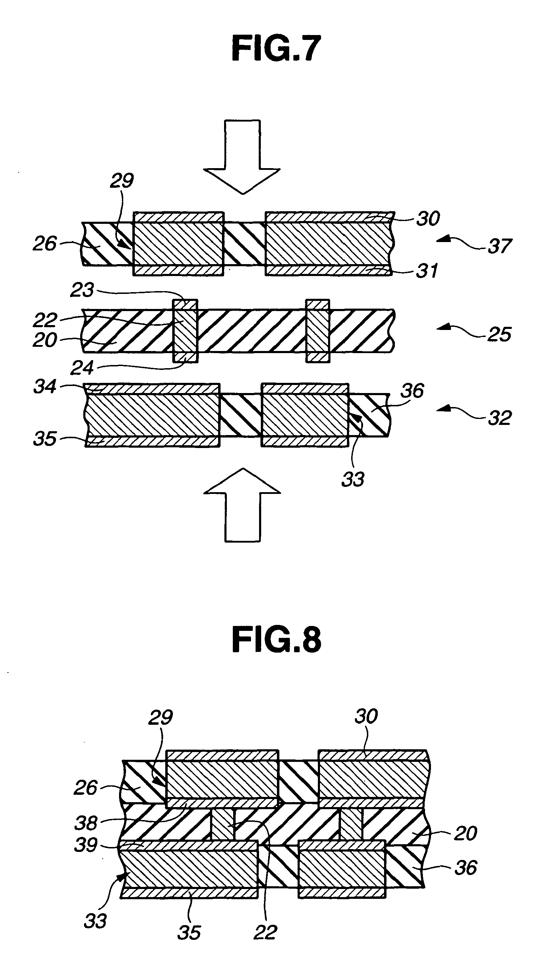

The via sheet 25 was sandwiched between the pattern sheets 32 and 37 so that the bonding gold-plated layers 30 and 35 were at outsides of a laminate. The laminate was heated and pressed by a vacuum press machine at 200°C for 120 minutes, as shown in Fig. 7. As shown in Fig. 8, the circuit pattern 29 was junctured to the copper 22 filling the vias with an alloy 38. The copper 22 filling the vias was junctured to the circuit pattern 33 with an alloy 39. The laminate had the bonding gold-plated surfaces 30 and 35. Thus, a multilayer circuit board (double-sided printed wiring board) according to the present invention was produced.

### Example 2

### (Production of via-forming sheet)

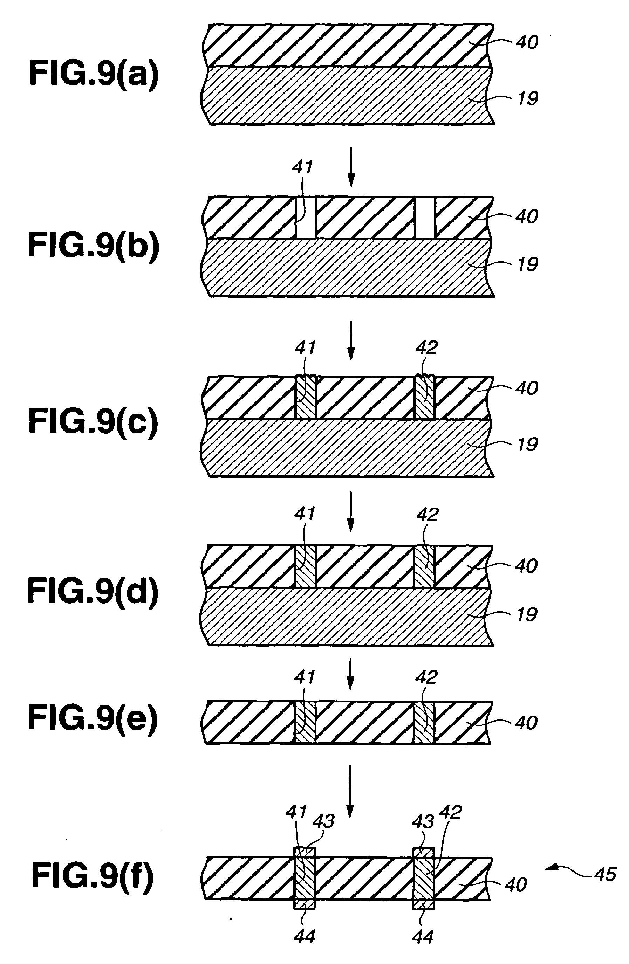

A thermosetting resin composition was coated on a stainless steel support 19 having a thickness of 100 µ, and dried at 160°C for 60 minutes to provide a coating film 40 having a thickness of 50 µ, as shown in Fig. 9a. Vias 41 each having a depth of 50 µ were formed in the coating film 40 using a carbon dioxide gas laser, as shown in Fig. 9b. The vias 41 were electroplated with copper 42 to a thickness of about 50 µ, whereby the vias 41 were completely filled with the copper 42, as shown in Fig. 9c. The surfaces of the copper 42 on the support 19 were polished by a ceramic buff at a load power of 1.5 ampere, as shown in Fig. 9d. After the polishing, the support 19 was peeled away, as shown in Fig. 9e . The surfaces of the vias 41 filled with the copper 42 was subjected to tin electroless plating to form plated layers 43 and 44, each having a thickness of 1 µ, on the surface of the via 41, as shown in Fig. 9f. Thus, a via sheet 45, i.e., a via-forming sheet, was produced.

In Example 2, the thermosetting resin composition is as follows (by weight): 100 parts of cresol novolac type epoxy resin, 90 parts of phenol novolac resin, 1 part of triphenyphosphine, 100 parts of barium sulfate, 1 part of an antifoaming agent, and 100 parts of a solvent.

### (Production of circuit pattern-forming sheet)

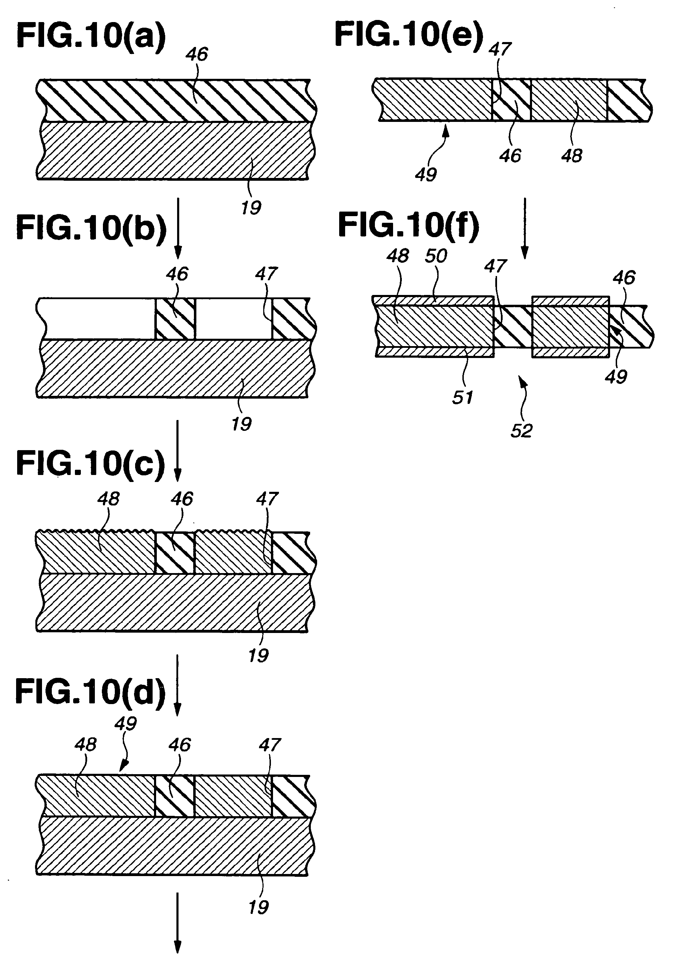

The above-described resin composition was coated on a stainless steel support 19 having a thickness of 100 µ, and dried at 160°C for 60 minutes to provide a coating film 46 having a thickness of 30 µ, as shown in Fig. 10a. Holes 47 for a circuit pattern each having a thickness of 30 µ were formed in the coating film 46 using a carbon dioxide gas laser, as shown in Fig. 10b . The holes 47 were electroplated with copper 48 to a thickness of about 50 µ, whereby the holes 47 were completely filled with the copper 48, as shown in Fig. 10c. The surface of the copper 48 on the support 19 was polished by a ceramic buff at a load power of 1.5 ampere to form a circuit pattern 49, as shown in Fig. 10d. Thereafter, the support 19 was peeled away, as shown in Fig. 10e. The surfaces of the circuit pattern 49 were electroless nickel-gold plated to form plated layers 50 and 51, each having a thickness of 1 µ, as shown in Fig. 10f. Thus, a pattern sheet 57, i.e., a circuit pattern-forming sheet, was produced.

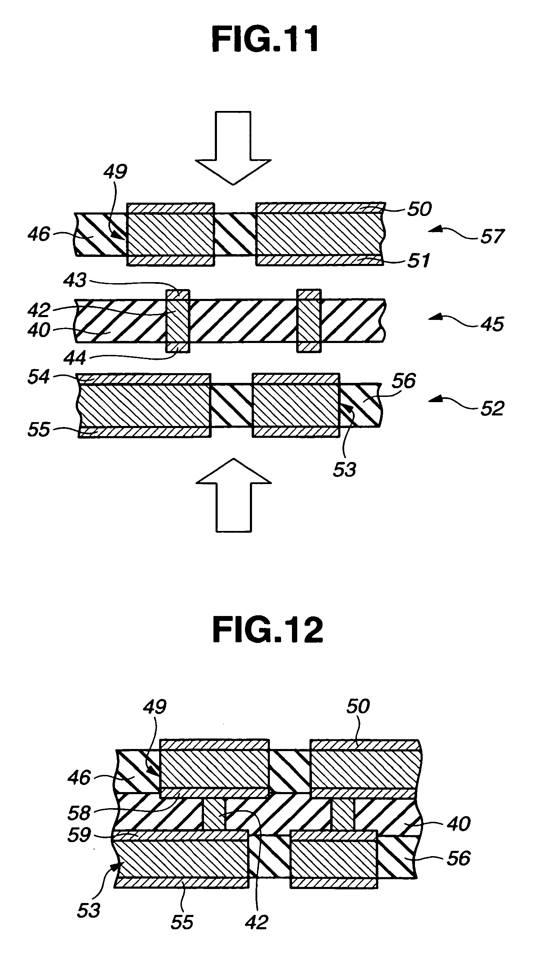

Similarly, a pattern sheet 52 including a circuit pattern 53 having plated layers 54 and 55 and a coating film 56 was produced, as shown in Fig. 11.

### (Production of multilayer circuit board)

The via sheet 45 was sandwiched between the pattern sheets 52 and 57, and was heated and pressed by a vacuum press machine at 200°C for 120 minutes, as shown in Fig. 11. The circuit pattern 49 was junctured to the copper 42 filling the via with an alloy 58. The copper 42 filling the vias were junctured to the circuit pattern 53 with an alloy 59. Thus, a multilayer circuit board (double-sided printed wiring board) according to the present invention was produced, as shown in Fig. 12.

### Example 3

### (Production of via-forming sheet)

Similar to Example 1, a thermosetting type PPE film was coated on the stainless steel support, and heated and cured by a vacuum press machine at 200°C for 2 hours. The vias were formed, and polished. The support was peeled away. The electroless tin - silver plating was subjected to form a plated layer having a thickness of 1 µ. Thus, a via sheet was produced.

### (Production of circuit pattern-forming sheet)

Similar to Example 1, two pattern sheets each having a thickness of 30 µ were produced.

### (Production of multilayer circuit board)

Similar to Example 1, the via sheet was sandwiched between two pattern sheets, and was heated and pressed by a vacuum press machine at 220°C for 120 minutes. Thus, a multilayer circuit board (double-sided printed wiring board) according to the present invention was produced.

According to the present invention, the vias and the conductor wiring layer are joined with an alloy in the multilayer circuit board, thereby providing excellent quality and reliability in a via connection between conductor wiring layers (circuit patterns) and generating less delamination.

Since there is no need to form through-holes in the multilayer circuit board of the present invention, it is possible to conduct automatic wiring using a CAD system. As a result, design time can be reduced.

The multilayer circuit board of the present invention can be produced using the sole and the same insulation material. In addition, the multilayer circuit board of the present invention can be produced using electroplating. It is possible to decrease electrical resistance. In the multilayer circuit board of the present invention, a film is used as an insulation layer, whereby the insulation layer can be uniform. Furthermore, in the multilayer circuit board of the present invention, a surface of a circuit pattern is not roughened. As a result, impedance matching and simulation can be easily performed.

According to the method of producing the multilayer circuit board of the present invention, perforation is conducted without etching. The circuit pattern has excellent shape stability. As a result, the impedance is well stabilized, and a high frequency can be applied.

In addition, the laminated board having bonding gold-plated surfaces can be produced by a batch press.

The via sheet and the pattern sheet can be produced using the same apparatus, thereby reducing the costs.

The resultant multilayer circuit board can be planarized so that a solder resist (SR) can be easily formed and mounted.

Furthermore, the substrate can have a mounting land surface. No solder resist is required. It is possible to reduce the steps and to prevent solder resist related defects, thereby further reducing the costs.

It is also possible to perforate the via sheet by laser beam machining as required so that passive parts such as a resistance and a capacitor are built-in.

## Claims

1. A multilayer circuit board comprising: a circuit pattern-forming sheet (16), and an insulation layer (7), wherein the circuit pattern-forming sheet (16) comprises a conductor wiring layer (5) and insulation material (8) adjacent the conductor wiring layer (5), the circuit pattern-forming sheet (16) and the insulation layer (7) being laminated alternately, the conductor wiring layer (5) being electrically connected by a via (4) through the insulation layer (7), the via (4) being filled with a conductor material (3), **characterized in that** the conductor material (3) is junctured to the conductor wiring layer (5) with an alloy (I), the components of which comprise plating metals formed on a surface of a planarized conductor material (3) and on a surface of a planarized conductor wiring layer (5), the alloy (1) being electrically connected to the conductor wiring layer (5) at a first junction surface and electrically connected to the conductor material (3) in the via (4) at a second junction surface.

2. A multilayered circuit board as claimed in claim 1, **characterised in that** the circuit board is a three-layered circuit board comprising two circuit pattern-forming sheets (16, 18), each comprising a conductor wiring layer (5, 6) and insulation material (8, 9) and an insulation layer (7) sandwiched there between.

3. A method of producing a multilayer circuit board, comprising the steps of:
laminating required numbers of via-forming sheets (12) and circuit pattern-forming sheets (16, 18) alternately to form a laminate, and thermally pressing both sides of the laminate,
**characterized in that** each via-forming sheet (12) is formed by forming a via (4) in an insulation layer (7), filling the via (4) with a conductor material (3), planarizing a surface of the conductor material (3), and plating the planarized surface with a plating metal selected from a pure metal or an alloy thereof, and
each circuit pattern-forming sheet (16, 18) is formed by perforating a hole for a circuit pattern in a layer of insulation material (8), filling the hole for the circuit pattern with a conductor material, planarizing a surface of the conductor material to form the circuit pattern, and plating a surface of the circuit pattern with a plating metal selected from a pure metal or an alloy thereof,
wherein upon pressing of the laminate, the plating metal on the conductor material (3) and the plating metal on the circuit pattern combine to form an alloy (1), said alloy (1) being selected from the group consisting of a tin-gold alloy, a tin-solder alloy, a tin-nickcl-gold alloy and a tin-silver alloy.

## Patentansprüche

1. Mehrschichtige Leiterplatte mit einer eine Schaltungsstruktur bildenden Lage (16) und einer Isolierschicht (7), wobei die Schaltungsstruktur-bildende Lage (16) eine Leiterverdrahtungschicht (5) und ein Isoliermaterial (8) benachbart zur Leiterverdrahtungschicht (5) aufweist, wobei die Schaltungsstruktur-bildende Lage (16) und die Isolierschicht (7) abwechselnd laminiert sind, wobei die Leiterverdrahtungschicht (5) über ein Via (4) durch die Isolierschicht (7) elektrisch verbunden ist, wobei das Via (4) mit Leitermaterial (3) gefüllt ist, **dadurch gekennzeichnet, dass** das Leitermaterial (3) an die Leiterverdrahtungschicht (5) mit einer Legierung (1) anschließt, deren Bestandteile Plattierungsmetalle aufweisen, die auf einer Oberfläche eines plan gemachten Leitermaterials (3) und auf einer Oberfläche einer plan gemachten Leiterverdrahtungschicht (5) gebildet sind, wobei die Legierung (1) an einer ersten Anschlussfläche mit der Leiterverdrahtungschicht (5) und an einer zweiten Anschlussfläche mit dem Leitermaterial (3) im Via (4) elektrisch verbunden ist.

2. Mehrschichtige Leiterplatte nach Anspruch 1, **dadurch gekennzeichnet, dass** die Leiterplatte eine dreischichtige Leiterplatte mit zwei eine Schaltungsstruktur bildenden Lagen (16, 18), von denen jede eine Leiterverdrahtungschicht (5, 6) und ein Isoliermaterial (8, 9) aufweist, sowie mit einer sandwichartig dazwischenliegenden Isolierschicht (7) ist.

3. Verfahren zur Herstellung einer mehrschichtigen Leiterplatte, umfassend die folgenden Schritte:
Laminieren der erforderlichen Anzahl von Via-bildenden Lagen (12) abwechselnd mit eine Schaltungsstruktur bildenden Lagen (16, 18) zur Bildung eines Laminats und Warmpressen beider Seiten des Laminats,
**dadurch gekennzeichnet, dass** jede Via-bildende Lage (12) durch Ausbilden eines Vias (4) in einer Isolierschicht (7), Füllen des Vias (4) mit Leitermaterial (3), Ebnen einer Oberfläche des Leitermaterials (3) und Plattieren der plan gemachten Oberfläche mit einem Plattierungsmetall, ausgewählt aus einem reinen Metall oder einer Legierung davon, gebildet wird, und
jede Schaltungsstruktur-bildende Lage (16, 18) durch Ausbilden eines Lochs für eine Schaltungsstruktur in einer Schicht aus Isoliermaterial (8), Füllen des Lochs für die Schaltungsstruktur mit Leitermaterial, Planmachen einer Oberfläche des Leitermaterials zur Bildung der Leiterstruktur und Plattieren einer Oberfläche der Schaltungsstruktur mit einem Plattierungsmetall, ausgewählt aus einem reinen Metall oder einer Legierung davon, gebildet wird,
wobei sich beim Pressen des Laminats das Plattierungsmetall auf dem Leitermaterial (3) und das Plattierungsmetall auf der Schaltungsstruktur zur Bildung einer Legierung (1) vereinen, welche Legierung (1) aus der Gruppe bestehend aus einer Zinn-Gold-Legierung, einer Zinn-Löt-Legierung, einer Zinn-Nickel-Gold-Legierung und einer Zinn-Silber-Legierung ausgewählt wird.

## Revendications

1. Carte de circuit multicouche, comprenant : une feuille de formation de tracé de circuit (16) et une couche isolante (7), dans laquelle la feuille de formation de tracé de circuit (16) comprend une couche de câblage conductrice (5) et un matériau isolant (8) adjacent à la couche de câblage électrique (5), la feuille de formation de tracé de circuit (16) et la couche isolante (7) étant stratifiées en alternance, la couche de câblage conductrice (5) étant connectée électriquement au moyen d'un trou d'interconnexion (4) à travers la couche isolante (7), le trou d'interconnexion étant rempli d'un matériau conducteur (3), **caractérisée en ce que** le matériau conducteur est relié à la couche de câblage conductrice (5) au moyen d'un alliage (1), dont les composants comprennent des métaux de placage formés sur une surface d'un matériau conducteur aplani (3) et sur une surface d'une couche de câblage conductrice aplanie (5), l'alliage (1) étant connecté électriquement à la couche de câblage conductrice (5) au niveau d'une première surface de jonction et connectée électriquement au matériau conducteur (3) dans le trou d'interconnexion (4) au niveau d'une seconde surface de jonction.

2. Carte de circuit multicouche selon la revendication 1, **caractérisée en ce que** la carte de circuit est une carte de circuit à trois couches comprenant deux feuilles de formation de tracé de circuit (16, 18) comportant chacune une couche de câblage conductrice (5, 6) et du matériau isolant (8, 9), ainsi qu'une couche isolante (7) prise en sandwich entre celles-ci.

3. Procédé de production d'une carte de circuit multicouche, comprenant les étapes consistant à :
stratifier en alternance un nombre requis de feuilles de formation de trous d'interconnexion (12) et de feuilles de formation de tracé de circuit (16, 18) de sorte à former un stratifié, et soumettre les deux côtés du stratifié à un pressage thermique,
**caractérisé en ce que** chaque feuille de formation de trous d'interconnexion (12) est formée selon les étapes consistant à former un trou d'interconnexion (4) dans une couche isolante (7), remplir le trou d'interconnexion (4) d'un matériau conducteur (3), aplanir une surface du matériau conducteur (3) et plaquer la surface aplanie d'un métal de placage sélectionné parmi un métal pur ou un alliage de celui-ci, et **en ce que**
chaque feuille de formation de tracé de circuit (16, 18) est formée selon les étapes consistant à forer un trou pour un tracé de circuit dans une couche dans une couche de matériau isolant (8), remplir le trou pour le tracé de circuit d'un matériau conducteur, aplanir une surface du matériau conducteur pour former le tracé de circuit, et plaquer une surface du tracé de circuit d'un métal de placage sélectionné parmi un métal pur ou un alliage de celui-ci,
dans lequel, suite au pressage du stratifié, le métal de placage sur la matériau conducteur (3) et le métal de placage sur le tracé de circuit se combinent pour former un alliage (1), ledit alliage (1) étant sélectionné dans le groupe constitué par un alliage étain/or, un alliage de soudure étain, un alliage étain/nickel/or et un alliage étain/argent.
